# EUROPEAN PATENT APPLICATION

(11) **EP 4 779 679 A1**
(43) Date of publication of application: **22.07.2026**
(21) Application number: 24865464.2
(22) Date of filing: 11.09.2024
(51) Int. Cl.: H01L 21/52, H05K 13/04

(54) **MOUNTING DEVICE AND MOUNTING METHOD**

(30) Priority: 11.09.2023 JP 2023147128
(71) Applicant: Yamaha Robotics Co., Ltd., Musashimurayama-shi, Tokyo 208-8585 (JP)
(72) Inventor: SAITO, Takashi, Musahimurayama-shi, Tokyo 2088585 (JP); NOMURA, Yudai, Musahimurayama-shi, Tokyo 2088585 (JP)
(74) Representative: Becker, Eberhard
(86) International application number: PCT/JP2024/032478
(87) International publication number: WO 2025/057964

(57) **Abstract**

Provided is a technology related to a mounting device capable of suppressing occurrence of mounting failure and also suppressing generation of dust. A mounting device 1 comprises: first movable pieces (22Ac, 22Bc...) provided in an upper die (20) and capable of moving up and down for applying pressure to upper surfaces of respective electronic components (CH11, CH21...); and at least one second movable piece (23Ac, 23Bc...) provided in the upper die (20) and capable of moving up and down independently of the first movable pieces (22Ac, 22Bc...). The mounting device (1) is configured such that the second movable pieces (23Ac, 23Bc...) apply pressure to upper surfaces of substrates (SB1, SB2...) and bonding materials (SN11, SN21...) that protrude from lower surfaces of the corresponding electronic components (CH11, CH21...) to the upper surfaces of the substrates (SB1, SB2...).

## Description

### Technical Field

The present invention relates to a mounting device and a mounting method using the device.

### Background Art

There are bonding technologies for heating a bonding material or bump disposed between a substrate and an electronic component while applying pressure. For example, sintering bonding is to sinter a bonding material disposed between a substrate and an electronic component such as a semiconductor chip by heating the bonding material while applying pressure. In the case of the range where the bonding material is disposed being narrower than the lower surface of the electronic component, the electronic component tends to peel off starting from locations without the bonding material. Therefore, the bonding material is supplied, for example, to cover the entire lower surface of the electronic component and slightly protrude from the lower surface of the electronic component to the upper surface of the substrate (see, for example, Patent Document 1).

### Related Art Document

### Patent Document

Patent Document 1: International Publication No. WO2020/261993

### SUMMARY OF THE INVENTION

### Problem to be Solved by the Invention

However, the pressure for pressing the electronic component does not act on the range that is not directly below the electronic component. The fillet-shaped bonding material that protrudes from the lower surface of the electronic component to the upper surface of the substrate is heated without being pressurized. Such bonding material is more brittle than a bonding material heated in a pressurized state between the electronic component and the substrate, and therefore may fall off and become dust that contaminates the inside of the mold.

The present invention has been made in view of such problems, and aims to provide a technology related to a mounting device that is capable of suppressing the occurrence of mounting defects and also suppressing the generation of dust.

### Means for Solving the Problem

A mounting device according to one aspect of the present invention is a mounting device for mounting at least one electronic component on each of at least one substrate by heating and pressurizing a bonding material, and includes: a lower mold configured to hold the substrate; an upper mold disposed opposite to the lower mold; a first movable piece provided in the upper mold and capable of moving up and down to pressurize an upper surface of each of the electronic components; and at least one second movable piece provided in the upper mold and capable of moving up and down independently of the first movable piece. The implementation device is configured such that the second movable piece pressurizes the bonding material protruding from a lower surface of the electronic component corresponding to the second movable piece to an upper surface of the substrate and the upper surface of the substrate.

A mounting method according to another aspect of the present invention is a mounting method for mounting at least one electronic component on each of at least one substrate by heating and pressurizing a bonding material, and includes: preparing a lower mold configured to hold the substrate; preparing an upper mold disposed opposite to the lower mold; preparing a first movable piece provided in the upper mold and capable of moving up and down to pressurize an upper surface of each of the electronic components; and preparing at least one second movable piece provided in the upper mold and capable of moving up and down independently of the first movable piece, and further includes the second movable piece pressurizing the bonding material protruding from a lower surface of the electronic component corresponding to the second movable piece to an upper surface of the substrate and the upper surface of the substrate.

### Effects of the Invention

According to the present invention, it is possible to provide a technology related to a mounting device that is capable of suppressing the occurrence of mounting defects and also suppressing the generation of dust.

### BRIEF DESCRIPTION OF THE DRAWINGS

[FIG. 1] is a cross-sectional view showing an example of the mounting device according to one embodiment of the present invention.
[FIG. 2] is a cross-sectional view enlarging the lower end portion of the through hole of the second movable piece.
[FIG. 3] is a plan view showing an example of arrangement of the elastic member connected to the second movable piece.
[FIG. 4] is a plan view showing another example of arrangement of the elastic member connected to the second movable piece.
[FIG. 5] is a flow diagram showing an example of the mounting method using the mounting device according to one embodiment of the present invention.
[FIG. 6] is a flow diagram showing an example of the mounting method using the mounting device according to one embodiment of the present invention, continuing from FIG. 5.
[FIG. 7] is a diagram showing a temperature profile of the mounting method shown in FIG. 5 and FIG. 6.
[FIG. 8] is a cross-sectional view showing a state in which the degassing chamber is closed and inert gas is supplied while degassing.
[FIG. 9] is a cross-sectional view showing a state in which the substrate is in contact with the heated cavity plate.
[FIG. 10] is a cross-sectional view showing a state in which the mold is closed, and the first movable piece and the second movable piece are in contact with the workpiece.
[FIG. 11] is a cross-sectional view showing a state in which the upper surface of the electronic component is pressurized by the first movable piece, and the protruding bonding material is pressurized by the second movable piece.

### DESCRIPTION OF THE EMBODIMENTS

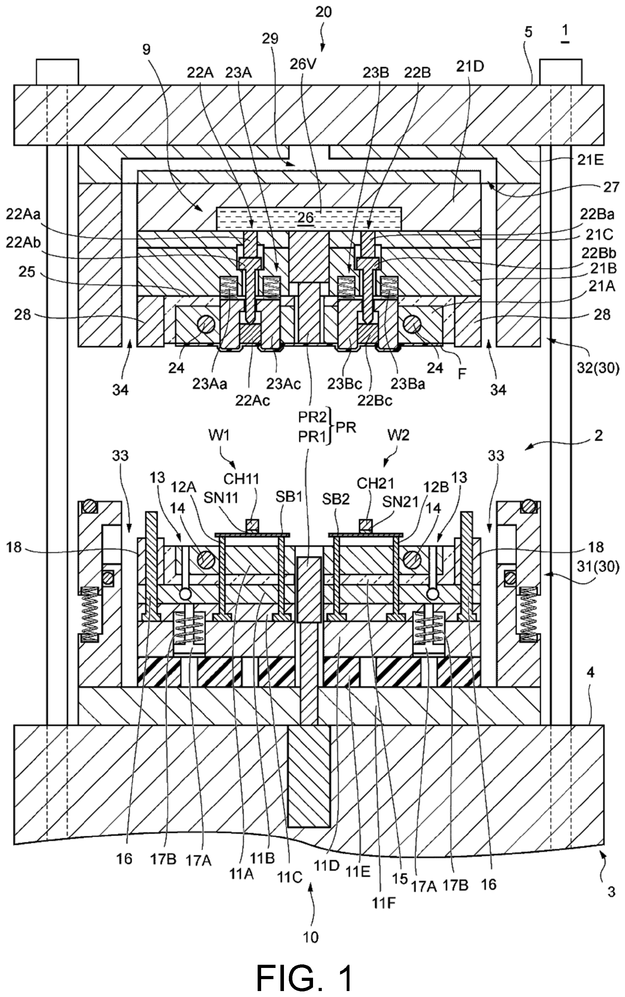

Preferred embodiments of the present invention will be described with reference to the accompanying drawings. In each drawing, components with the same reference numerals have the same or similar configurations. In the following description, "upper" and "lower" are defined based on gravity. FIG. 1 is a cross-sectional view showing an example of a mounting device 1 according to one embodiment of the present invention. The mounting device 1 is a mounting device for mounting at least one electronic component CH11, CH21 on each of at least one substrate SB1, SB2.

In the illustrated example, the mounting device 1 is configured as a sintering device that sinters a bonding material SN11 disposed between the substrate SB1 and the electronic component CH11 by heating and pressurizing the bonding material SN11 to bond the substrate SB1 and the electronic component CH11. The present invention is not limited to a sintering device, and may also be applied to a technology based on resin encapsulation molding using thermosetting resin that pressurizes the bonding material protruding from the lower surface of the electronic component CH11 to the upper surface of the substrate SB1. In the following description, the substrate SB1, the electronic component CH11, and the bonding material SN11 are collectively called workpiece W1.

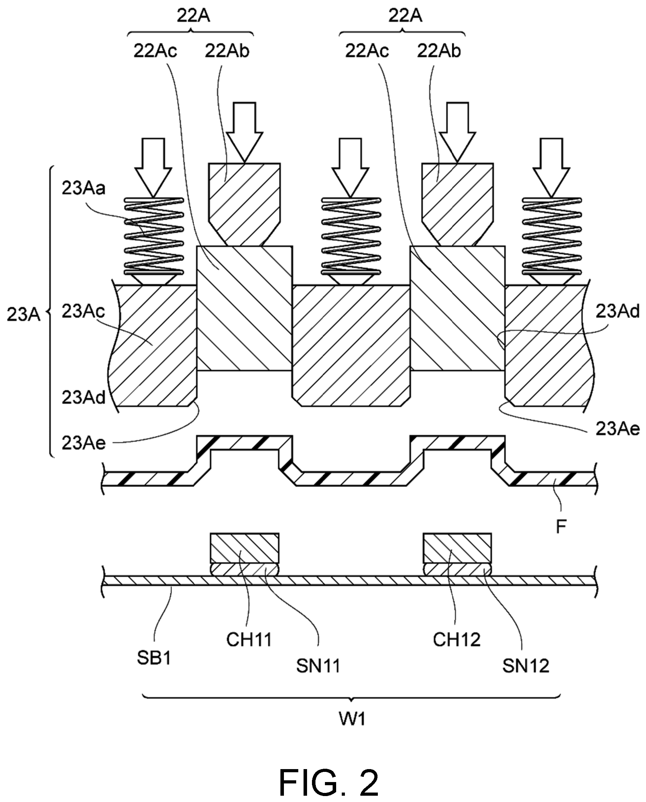

The mounting device 1 may perform mounting processing on multiple workpieces with one heating and pressurizing operation. In the illustrated example, the mounting processing is performed on two workpieces W1 and W2 with one heating and pressurizing operation. The other workpiece W2 includes the substrate SB2, the electronic component CH21, and a bonding material SN21, similar to the workpiece W1. Two or more electronic components CH11, CH12... may be simultaneously mounted on each substrate SB1 (shown in FIG. 2). The electronic components may be arranged in a matrix in multiple rows and multiple columns. In addition, although two workpieces are arranged left and right, the number of workpieces is not limited to two. Furthermore, multiple workpieces may be arranged from back to front.

In the space between a lower mold 10 and an upper mold 20, the workpiece W1 is supplied with the substrate SB1 facing the lower mold 10 and the electronic component CH11 facing the upper mold 20, and the workpiece W2 is supplied with the substrate SB2 facing the lower mold 10 and the electronic component CH21 facing the upper mold 20. In the following description, the surfaces on which the electronic components CH11 and CH21 are mounted are called the upper surfaces or front surfaces of the substrates SB1 and SB2, and the surfaces on the opposite side are called the lower surfaces or back surfaces of the substrates SB1 and SB2.

Preferred examples of the substrates SB1 and SB2 are Direct Bonded Copper (DBC) substrates of high heat dissipation ceramic insulation with copper circuit, Direct Bonded Aluminum (DBA) substrates of high heat dissipation ceramic insulation with aluminum circuit, and the like. The substrates 102 are not limited to ceramic substrates, and may be semiconductor substrates such as silicon substrates, metal substrates such as lead frames, or insulator substrates such as PCB (Printed Circuit Board) substrates. The thicknesses of the substrates SB1 and SB2 may be different from each other or may be the same, for example.

The electronic components CH11 and CH21 are, for example, semiconductor chips. The electronic components CH11 and CH21 are not limited to semiconductor chips, and may be passive elements such as resistors, inductors, capacitors, crystal oscillators or may be active elements such as diodes, transistors, thyristors, and operational amplifiers. The heights of the electronic components CH11 and CH21 may be different from each other or may be the same.

The bonding materials SN11 and SN21 are, for example, sintering materials including silver (Ag) nanoparticles. The mounting device 1 heats and pressurizes the bonding materials SN11 and SN21, which are aggregates of powder, to sinter the bonding materials SN11 and SN21. As shown in FIG. 1, the mounting device 1 includes a press device 3 and a mold 2 attached to the press device 3. In the illustrated example, the mounting device 1 further includes a degassing chamber 30. The press device 3 includes a pair of lower platen 4 and upper platen 5 that are connected by tie bars.

The mold 2 includes an upper mold base 21E fixed to the upper platen 5 and a lower mold base 11F fixed to the movable platen 4. The movable platen 4 is capable of moving up and down by a drive mechanism (not shown), but the lower side is not necessarily driven, and the upper platen side may be moved up and down. Between the upper mold base 21E and the lower mold base 11F, the main plates constituting the mold 2 (support plates 21D and 21C, upper mold chase 21B, lower mold chase 11B, ejector pin plate 11C, retainer plate 11D, etc.) are fixed.

In the following description, various plates fixed to the lower mold base 11F and components thereof are collectively called the lower mold 10, and various plates fixed to the upper mold base 21E and components thereof are collectively called the upper mold 20. The lower mold 10 is configured to hold the workpieces W1 and W2, and the upper mold 20 is disposed opposite to the first mold.

The lower mold 10 mainly includes a lower mold base 11F, a support pillar 11E, a retainer plate 11D, an ejector pin plate 11C, a lower mold chase 11B, etc. The lower mold chase 11B is fixed above the lower mold base 11F via multiple support pillars 11E that protrude in a columnar shape from the lower mold base 11F.

The ejector pin plate 11C and the retainer plate 11D are disposed below the lower mold chase 11B. The ejector pin plate 11C and the retainer plate 11D have holes through which the support pillars 11E penetrate. The ejector pin plate 11C and the retainer plate 11D are fixed to each other and are configured to be slidable vertically between the lower mold chase 11B and the lower mold base 11F.

Various components including a cavity plate 11A are fixed to the lower mold chase 11B. In the illustrated example, the cavity plate 11A, a side block 18 that fixes the cavity plate 11A, a thermal insulation member 15 disposed to surround the lower surface and side surfaces of the cavity plate 11A, a spring 17B, and a spring sleeve 17A are fixed to the lower mold chase 11B.

Both the ejector pin plate 11C and the retainer plate 11D face the cavity plate 11A from the lower side opposite to the upper mold 20. Multiple lifter pins 12A and 12B that can protrude from and retract into the cavity plate 11A, and a set pin 16 that comes into contact with the upper mold 20 in the case of mold closing, are fixed to the ejector pin plate 11C and the retainer plate 11D.

In response to both the ejector pin plate 11C and the retainer plate 11D approaching the cavity plate 11A, the lifter pins 12A and 12B protrude from the cavity plate 11A, and in response to both the ejector pin plate 11C and the retainer plate 11D moving away from the cavity plate 11A, the lifter pins 12A and 12B retract into the cavity plate 11A.

The cavity plate 11A is formed in a block shape using a material such as alloy tool steel. The cavity plate 11A is provided at a position closest to the upper mold 20 and is adjacent to the space between the lower mold 10 and the upper mold 20 during mold opening. A heater 14 is provided inside the cavity plate 11A. The heater 14 heats the substrates SB1 and SB2 via the cavity plate 11A in the case of the lower mold 10 and the upper mold 20 being closed. Thereby, the bonding materials SN11 and SN21 are heated.

The thermal insulation member 15 is provided between the cavity plate 11A and the lower mold chase 11B, and between the cavity plate 11A and the side block 18. The thermal insulation member 15 is formed of a material with a large thermal resistance value such as glass wool or rock wool, and suppresses direct heat conduction from the cavity plate 11A to the lower mold chase 11B and suppresses heat conduction from the cavity plate 11A to the lower mold chase 11B via the side block 18.

In other words, the thermal insulation member 15 is disposed to separate the gas piping provided in the lower mold chase 11B from the heater 14, and suppresses an increase in temperature of the nitrogen gas or the like supplied from a gas supply port 13. Further, the thermal insulation member 15 is disposed to separate the spring 17B from the heater 14, and suppresses a decrease in elastic force of the spring 17B. That is, the thermal insulation member 15 limits the heating target to the cavity plate 11A, thereby accelerating the temperature rise of the heater 14 and making other members less susceptible to the influence of heat.

The side block 18 is provided outside the cavity plate 11A in plan view from the upper mold 20. The side block 18 comes into contact with the upper mold 20 in the case of the lower mold 10 and the upper mold 20 being closed. In the illustrated example, the gas supply port 13 for supplying gas such as nitrogen (N₂) gas to the cavity plate 11A is provided in a region outside the heater 14.

The spring 17B biases the ejector pin plate 11C and the retainer plate 11D upward toward the lower mold chase 11B. The base portion, that is, the upper end portion of the spring sleeve 17A is a stepped bolt and is fixed to the lower surface of the lower mold chase 11B. The base portion of the spring sleeve 17A may be a combination of a washer, a sleeve, and a bolt. A flange is provided at the tip portion, that is, the lower end portion of the spring sleeve 17A.

The retainer plate 11D has a through hole formed therein that is larger than the tip portion of the spring sleeve 17A. The ejector pin plate 11C has a counterbore with the same diameter as the through hole and a through hole formed at the center of the counterbore through which the base portion of the spring sleeve 17A is inserted. The spring sleeve 17A is inserted through the through hole of the retainer plate 11D and the through hole of the ejector pin plate 11C.

The spring 17B is provided in a helical manner around the spring sleeve 17A between the flange of the spring sleeve 17A and the counterbore of the ejector pin plate 11C. That is, the spring sleeve 17A is inserted into the helical spring 17B. The spring 17B applies an elastic force in a direction that separates the ejector pin plate 11C and the flange of the tip portion of the spring sleeve 17A from each other. The spring 17B is not limited to a coil spring, and may be a leaf spring or the like.

The lifter pins 12A and 12B are inserted into the through holes that penetrate the cavity plate 11A, the lower mold chase 11B, the ejector pin plate 11C, and the thermal insulation member 15. The lifter pins 12A and 12B have the same length, and three to four or more lifter pins are used for holding in order to keep the workpiece W1 parallel. The upper mold 20 side is the tip portion, and the lower mold base 11F side is the base portion. The base portions of the lifter pin 12B and the set pin 16 are sandwiched between the ejector pin plate 11C and the retainer plate 11D and are screwed. The lifter pin 12B and the set pin 16 move up and down in conjunction with the ejector pin plate 11C and the retainer plate 11D.

Each of the lifter pins 12A and 12B is, for example, formed in a rod shape. The lifter pin 12A supports the substrate SB1 by bringing the tip portion thereof into contact with the back surface of the substrate SB1, and the lifter pin 12B supports the substrate SB2 by bringing the tip portion thereof into contact with the back surface of the substrate SB2. The lifter pins 12A and 12B are configured to be movable up and down, and bring the substrates SB1 and SB2 into contact with and separate the substrates SB1 and SB2 from the cavity plate 11A.

Specifically, the lifter pins 12A and 12B are configured to be able to advance from the cavity plate 11A toward the upper mold 20 and retract. In the case of the lifter pins 12A and 12B advancing into the space between the lower mold 10 and the upper mold 20, that is, during mold opening, the workpieces W1 and W2 supported by the lifter pins 12A and 12B are separated from the cavity plate 11A. In the case of the lifter pins 12A and 12B retracting from the space between the lower mold 10 and the upper mold 20, that is, during mold closing, the workpieces W1 and W2 are supported in contact with the cavity plate 11A.

In response to the ejector pin plate 11C and the retainer plate 11D approaching the cavity plate 11A (moving upward), the tip portions of the lifter pins 12A and 12B protrude from the cavity plate 11A. That is, the tips of the lifter pins 12A and 12B advance into the space between the lower mold 10 and the upper mold 20.

In response to the ejector pin plate 11C and the retainer plate 11D moving away from the cavity plate 11A (moving downward), the tip portions of the lifter pins 12A and 12B are housed inside the cavity plate 11A, and the surfaces of the surface end portions of the lifter pins 12A and 12B become flush with the surface of the cavity plate 11A. That is, the lifter pins 12A and 12B retract from the space between the lower mold 10 and the upper mold 20.

The substrates SB1 and SB2 are supported by the tip portions (upper end portions) of the lifter pins 12A and 12B. Each of the lifter pins 12A and 12B is fixed to the ejector pin plate 11C and the retainer plate 11D, which are movable plates, in a state of being inserted into the through hole that penetrates the cavity plate 11A.

The set pin 16 is inserted through a through hole that penetrates the side block 18, the lower mold chase 11B, and the ejector pin plate 11C. The set pin 16 uses the upper mold 20 side as the tip portion and the lower mold base 11F side as the base portion. The base portion of the set pin 16 is sandwiched between the ejector pin plate 11C and the retainer plate 11D. The tip portion of the set pin 16 faces the side block 28 of the upper mold 20.

In the case of the lower mold 10 and the upper mold 20 being closed, the set pin 16 is pressed by the side block 28 and presses down the ejector pin plate 11C and the retainer plate 11D. By pressing down the ejector pin plate 11C and the retainer plate 11D, the lifter pin 12B is pressed down in conjunction, causing the substrates SB1 and SB2 on the lifter pin 12B to move downward. Further, in order to press down the ejector pin plate 11C and the retainer plate 11D in parallel, it is preferable to dispose the set pins 16 at the four corners of the lower mold 10.

The upper mold 20 mainly includes an upper mold base 21E, an upper support plate 21D, a lower support plate 21C, an upper mold chase 21B, a pressure adjustment mechanism 9, etc. The upper support plate 21D and the lower support plate 21C are fixed to the upper mold base 21E. The upper mold chase 21B is fixed to the upper mold base 21E via the upper support plate 21D and the lower support plate 21C.

Various components including a cavity plate 21A are fixed to the upper mold chase 21B. In the illustrated example, the upper mold chase 21B is provided with the cavity plate 21A, the side block 28 that fixes the cavity plate 21A, the thermal insulation member 25 that is disposed to surround the upper surface and side surfaces of the cavity plate 21A, and a part of the pressure adjustment mechanism 9. The pressure adjustment mechanism 9 will be described in detail later.

The cavity plate 21A is provided at a position closest to the lower mold 10. A heater 24 is provided inside the cavity plate 21A. The heater 24 heats first movable pieces 22Ac and 22Bc and second movable pieces 23Ac and 23Bc, which will be described later, via the cavity plate 21A. In the case of the lower mold 10 and the upper mold 20 being closed, the heater 24 heats the electronic components CH11 and CH21 via the first movable pieces 22Ac and 22Bc and a film F. Thereby, the bonding materials SN11 and SN21 are heated.

The side block 28 is provided on the side of the upper mold chase 21B that faces the lower mold 10. In plan view from the upper mold 20, the side block 28 is provided outside the cavity plate 21A. The side block 28 is a portion of the upper mold 20 that comes into contact with the lower mold 10 in the case of the lower mold 10 and the upper mold 20 being closed. The side block 28 fixed to the upper mold chase 21B faces the side block 18 fixed to the lower mold chase 11B in the vertical direction.

The above-mentioned set pin 16 is an example of the "pressing member" that is pressed by the upper mold 20, which is the second mold. In the case of the lower mold 10 and the upper mold 20 being closed, the side block 28 of the upper mold 20 comes into contact with and presses the set pin 16. In the case of the lower mold 10 and the upper mold 20 being closed, the side block 28 may be separated from the set pin 16.

The thermal insulation member 25 is provided between the cavity plate 21A and the upper mold chase 21B, and is provided between the cavity plate 21A and the side block 28. The thermal insulation member 25 suppresses direct heat conduction from the cavity plate 21A to the upper mold chase 21B, and suppresses heat conduction from the cavity plate 21A to the upper mold chase 21B via the side block 28.

The thermal insulation member 25 suppresses thermal deterioration of elastic members 23Aa and 23Ba such as coil springs by partitioning the heater 24 and a closed space 26. That is, the thermal insulation member 25 limits the heating target to the cavity plate 21A, thereby accelerating the temperature rise of the heater 24 and making other members less susceptible to the influence of heat.

In the case of performing the mounting processing, the film F is stretched on the surface of the cavity plate 21A that faces the lower mold 10. Suction holes (not shown) for suctioning the film F are formed on the lower surface of the cavity plate, and the film F is adsorbed. The suction holes are connected to an external vacuum suction pump.

As examples of the film F, film materials that are excellent in heat resistance, easy peelability, flexibility, and extensibility are suitably used, such as PTFE (polytetrafluoroethylene), ETFE (ethylene-tetrafluoroethylene copolymer), PET (polyethylene terephthalate), FEP (tetrafluoroethylene-hexafluoropropylene copolymer), fluorine-impregnated glass cloth, PP (polypropylene), and PVDC (polyvinylidene chloride).

The film F inhibits intrusion of powder and gas generated from the bonding materials SN11 and SN21 into gaps of the upper mold 20, and suppresses malfunction of the upper mold 20. Additionally, the film F functions as a cushioning material between the first movable pieces 22Ac and 22Bc and the electronic components CH11 and CH21, and has an effect of suppressing damage to the electronic components CH11 and CH21 during pressurization.

The upper mold 20 includes the pressure adjustment mechanism 9 that adjusts the pressure applied to each of the electronic components CH11 and CH21 such that the electronic components CH11 and CH21 do not have damage or mounting defects due to insufficient pressure or excessive pressure on the bonding materials SN11 and SN21 caused by dimensional differences of the substrates SB1 and SB2 and the electronic components CH11 and CH21.

In the illustrated example, the pressure adjustment mechanism 9 includes a viscous member 26V such as silicone oil sealed in the closed space 26 within the upper mold 20, a plunger PR that pressurizes the viscous member 26V to adjust the internal pressure, first movable mechanisms 22A and 22B that receive the internal pressure of the viscous member 26V and pressurize the upper surfaces of the electronic components CH11 and CH21, etc. Various components constituting the pressure adjustment mechanism 9 are arranged across the upper mold chase 21B, the upper support plate 21D, and the lower support plate 21C.

In this configuration, pressure equal to the internal pressure of the viscous member is applied to all the pistons, so it is possible to absorb the differences in thickness of the substrates SB1 and SB2, differences in height of the electronic components CH11 and CH21, and differences in thickness of the bonding materials SN11 and SN21, and pressurize the bonding materials SN11 and SN21 with uniform pressure.

In the illustrated example, the pressure adjustment mechanism 9 includes an upper plunger PR2 that is provided in the upper mold 20 and capable of advancing and retracting such that the volume of the closed space 26 contracts and expands, and a lower plunger PR1 that is provided in the lower mold 10 and comes into contact with the upper plunger PR2 to cause the upper plunger PR2 to advance and retract during heating and pressurization of the bonding materials SN11 and SN21. Since the plunger for adjusting the internal pressure of the viscous member 26V can be divided into the lower plunger PR1 and the upper plunger PR2, there are fewer constraints in design than a configuration in which the plunger PR cannot be divided, making it possible to achieve miniaturization of the mounting device 1. Additionally, there is an advantage that the lower plunger movable mechanism of an existing transfer molding press can be used directly.

The first movable mechanisms 22A and 22B are connected to the closed space 26 and configured to be capable of moving up and down. The first movable mechanisms 22A and 22B respectively use the upper mold base 21E side as the base portion and the lower mold 10 side as the tip portion. The piston 22Aa at the base portion receives the internal pressure of the closed space 26 that rises in response to the plunger PR pressing the viscous member 26V, and moves up and down. The first movable piece 22Ac at the tip portion comes into contact with the electronic component CH11 via the film F and pressurizes the electronic component CH11 by the internal pressure of the closed space 26 transmitted from the base portion.

That is, the electronic component CH11 is pressurized by the first movable piece 22Ac that receives the internal pressure of the viscous member 26V based on the pressing force of the plunger PR pressing the viscous member 26V. The bonding material SN11 is pressurized by the first movable piece 22Ac via the electronic component CH11. Similarly, the electronic component CH12 is pressurized by the first movable piece 22Bc that receives the internal pressure of the viscous member 26V based on the pressing force of the plunger PR pressing the viscous member 26V, and the bonding material SN21 is pressurized by the first movable piece 22Bc via the electronic component CH21.

The internal pressure of the closed space 26 acting on each of the first movable mechanisms 22A and 22B is uniform regardless of the positions of the first movable pieces 22Ac and 22Bc in the vertical direction where the lower mold 10 and the upper mold 20 face each other. Therefore, the bonding materials SN11 and SN21 are pressurized with uniform pressure without being affected by differences in thickness of the substrates SB1 and SB2, differences in height of the electronic components CH11 and CH21, and differences in thickness of the bonding materials SN11 and SN21.

The first movable mechanism 22A includes a piston 22Aa, a rod 22Ab, and the first movable piece 22Ac. The piston 22Aa is provided at the base portion of the first movable mechanism 22A. The piston 22Aa is connected to the closed space 26. That is, the piston 22Aa is in contact with the viscous member 26V. The piston 22Aa is provided to be slidable relative to the upper mold chase 21B and the lower support plate 21C. The piston 22Aa and the lower support plate 21C are in liquid-tight contact to prevent leakage of the viscous member 26V. The piston 22Aa receives the internal pressure of the closed space 26 that changes due to the pressing of the viscous member 26V imposed by the plunger RP, and moves in the vertical direction.

The rod 22Ab is provided between the piston 22Aa and the first movable piece 22Ac. The rod 22Ab is provided to be slidable relative to the cavity plate 21A, the upper mold chase 21B, and the thermal insulation member 25. The rod 22Ab is connected to the piston 22Aa at the base portion, and the tip portion is rounded in a bullet shape and makes point contact with the first movable piece 22Ac. The rod 22Ab transmits pressure between the piston 22Aa and the first movable piece 22Ac.

The first movable piece 22Ac is provided at the tip portion of the first movable mechanism 22A. The first movable piece 22Ac is provided to be slidable relative to the cavity plate 21A. The tip portion of the first movable piece 22Ac protrudes from the cavity plate 21A. The first movable piece 22Ac is a movable nested component that moves up and down and is prevented from falling. In the case of the lower mold 10 and the upper mold 20 being closed, the tip portion of the first movable piece 22Ac comes into contact with the upper surface of the electronic component CH11 via the film and applies the pressure transmitted from the piston 22Aa to the electronic component CH11. Similar to the first movable mechanism 22A, the first movable mechanism 22B includes a piston 22Ba, a rod 22Bb, and the first movable piece 22Bc. The sides of the first movable pieces 22Ac and 22Bc that are in contact with the electronic components CH11 and CH21 are covered by the continuous film F.

The closed space 26 is formed between the lower support plate 21C and the upper support plate 21D. The pistons 22Aa and 22Ba of the first movable mechanisms 22A and 22B and the upper plunger PR2 of the plunger PR are connected to the closed space 26. That is, the inner wall of the closed space 26 is constituted by the lower support plate 21C, the upper support plate 21D, the pistons 22Aa and 22Ba, and the upper plunger PR2. The closed space 26 is independent from the external space of the upper mold 20. That is, the closed space 26 is a closed system in which the viscous member 26V does not enter or exit from the upper mold 20.

The viscous member 26V is sealed in the closed space 26. The viscous member 26V is a fluid having higher viscosity than water. For example, the viscosity coefficient of the viscous member 26V at 25°C is 1 Pa·s or more and 200 Pa·s or less. The material of the viscous member 26V is, for example, silicone oil, but is not limited thereto. Due to the viscosity, the viscous member 26V is less likely to leak from the gap between the lower support plate 21C and the upper plunger PR2 or the gap between the lower support plate 21C and the pistons 22Aa and 22Ba than water or air.

Further, since the viscous member 26V has a smaller compression ratio than gas such as air, sealing the viscous member 26V instead of gas in the closed space 26 makes it possible to reduce loss of the pressing force imposed by the plunger PR in the closed space 26. It is desirable that the material of the viscous member 26V is a material with excellent heat resistance. Specifically, it is desirable that the material of the viscous member 26V is a material having little change in viscosity in the temperature change range of the upper mold chase 21B, the lower support plate 21C, and the upper support plate 21D in the case of the heater 24 heating the cavity plate 21A.

The lower plunger PR1 is detachably erected on a plunger unit which is a known transfer drive source (not shown, see Japanese Patent Application Laid-Open No. 9-155911, Japanese Patent Application Laid-Open No. 2013-26360, and Japanese Patent Application Laid-Open No. 2019-1122 as examples) provided at the lower portion of the movable platen that moves the lower mold 10 up and down. In the case of normal transfer molding, an equal pressure mechanism is incorporated in the plunger unit, but in the case of the present invention, the equal pressure mechanism may not be required. The lower plunger PR1 is inserted through a through hole that penetrates the cavity plate 11A, the lower mold chase 11B, the ejector pin plate 11C, the retainer plate 11D, the thermal insulation member 15, the support pillar 11E, and the lower mold base 11F.

The lower plunger PR1 uses the upper mold 20 side as the tip portion and the opposite side as the base portion. The tip portion of the lower plunger PR1 has a larger diameter than the base portion of the lower plunger PR1. A pot (not shown) may be provided in the lower mold 10, and the tip portion of the lower plunger PR1 may be disposed inside the pot for guidance. The lower plunger PR1 is configured to be capable of moving up and down by the plunger unit (not shown). In the case of the lower plunger PR1 moving down to the limit of the movable range, the tip of the lower plunger PR1 is housed in the cavity plate 11A, for example, but the upper surface of the tip of the lower plunger PR1 may be at the same surface height as the upper surface of the cavity plate 11A.

In the case of the lower plunger PR1 moving upward, the tip of the lower plunger PR1 protrudes from the cavity plate 11A. In the case of the lower mold 10 and the upper mold 20 being closed and the lower plunger PR1 moving upward, the tip of the lower plunger PR1 comes into contact with the tip of the upper plunger PR2. In the case of the lower plunger PR1 further moving upward, the lower plunger PR1 presses the upper plunger PR2 upward. The base portion of the lower plunger PR1 is connected to the plunger unit (not shown).

In the illustrated example, only one lower plunger PR1 is shown, but the plunger PR may have multiple lower plungers PR1. Such multiple lower plungers PR1 may be arranged, for example, in the depth direction of the drawing of FIG. 1. In the illustrated example, the electronic components CH11 and CH21 correspond one-to-one with the same number as the first movable pieces 22Ac and 22Bc. The first movable pieces 22Ac and 22Bc may be fewer than the electronic components CH11 and CH21. In that case, multiple electronic components (for example, electronic components CH11 and CH21) may be pressed by one movable piece (for example, first movable piece 22Ac).

The upper plunger PR2 is provided in the upper mold 20. The upper plunger PR2 is inserted through a through hole that penetrates the cavity plate 21A, the upper mold chase 21B, the lower support plate 21C, and the thermal insulation member 25. The upper plunger PR2 uses the lower mold 10 side as the tip portion and the opposite side as the base portion. The base portion (upper end surface) of the upper plunger PR2 has a larger diameter than the tip portion of the upper plunger PR2 and is provided to be slidable relative to the upper mold chase 21B and the lower support plate 21C.

A pot (not shown) may be provided in the upper mold 20, and the base portion of the upper plunger PR2 may be disposed inside the pot for guidance. The base portion of the upper plunger PR2 is connected to the closed space 26. The tip portion (lower end surface) of the upper plunger PR2 is at the same surface height as the lower end surface of the cavity plate 21A and is exposed from the lower end surface of the cavity plate 21A. The upper plunger PR2 is pressed by the lower plunger PR1 and presses the viscous member 26V.

In the cross-section shown in FIG. 1, only one upper plunger is illustrated, but the plunger may have multiple upper plungers. In this case, the closed space 26 may be separated for each lower plunger PR1. Such multiple upper plungers are arranged, for example, in the depth direction of the drawing of FIG. 1. Each of the multiple upper plungers forms a pair with each of the multiple lower plungers, constituting multiple pairs of plungers. The multiple pairs of plungers are capable of transmitting pressing independently of each other.

A pressing transmission mechanism has the lower plunger PR1 and the upper plunger PR2, and is not limited to the plunger PR that presses the viscous member 26V from below the closed space 26. The pressing transmission mechanism may be configured to press the viscous member 26V from above the closed space 26, or may be configured to press the viscous member 26V from the lateral direction of the closed space 26. Here, the lateral direction refers to a direction that intersects with the direction in which the lower mold 10 and the upper mold 20 face each other. The pressing transmission mechanism may be configured to press the viscous member 26V from multiple directions of the closed space 26.

In the case of performing the mounting processing, the sides of the rods 22Ab and 22Bb that are in contact with the electronic components CH11 and CH21 are covered by the continuous film F. The film F prevents dust generated from the bonding materials SN11 and SN21 from adhering to and contaminating the upper mold 20.

The heater 24 heats the rods 22Ab and 22Bb via the cavity plate 21A. In the case of the lower mold 10 and the upper mold 20 being combined, the heater 24 heats the electronic components CH11 and CH21 via the rods 22Ab and 22Bb. Thereby, the bonding materials SN11 and SN21 are heated. The heater 24 is provided inside the cavity plate 21A. The heater 24 is, for example, a sheathed heater.

The degassing chamber 30 is an openable and closable annular vacuum chamber that surrounds the lower mold 10 and the upper mold 20, and includes a lower chamber 31 and an upper chamber 32. The lower chamber 31 is erected on the lower mold base 11F of the lower mold 10. In plan view from the upper mold 20, the lower chamber 31 is provided outside the side block 18. A degassing path 33 through which degassing gas passes is provided between the lower chamber 31 and the lower mold chase 11B, the ejector pin plate 11C, the retainer plate 11D, the support pillar 11E, and the side block 18.

The upper chamber 32 is erected downward from the upper mold base 21E of the upper mold 20 at a position in contact with the lower chamber 31. In plan view from the lower mold 10, the upper chamber 32 is provided outside the side block 28. A degassing path 34 through which degassing gas passes is provided between the upper chamber 32 and the upper mold chase 21B, the lower support plate 21C, the upper support plate 21D, and the side block 28.

The degassing path 34 is connected to a degassing path 27 provided in the upper mold base 21E. The degassing path 27 is connected to a degassing port 29 provided in the upper mold base 21E. The degassing port 29 is connected to a vacuum pump outside the mold. Through the degassing port 29, the atmosphere of the lower mold 10 and the upper mold 20 within the degassing chamber 30 composed of the lower chamber 31 and the upper chamber 32 is degassed.

One of the features of the mounting device 1 according to the present embodiment is that the mounting device 1 includes the second movable pieces 23Ac, 23Bc... The second movable piece 23Ac is configured to pressurize at least one of the bonding material SN11 that protrudes from the lower surface of the electronic component CH11 to the upper surface of the substrate SB1 and the upper surface of the substrate SB1 by the elastic force of the elastic member 23Aa in the case of the first movable piece 22Ac pressurizing the upper surface of the electronic component CH11. Similarly, the second movable piece 23Bc is configured to pressurize at least one of the bonding material SN21 that protrudes from the lower surface of the electronic component CH21 to the upper surface of the substrate SB2 and the upper surface of the substrate SB2 by the elastic force of the elastic member 23Ba in the case of the first movable piece 22Bc pressurizing the upper surface of the electronic component CH21.

The upper end portion of the second movable piece 23Ac is connected to the elastic member 23Aa such as a coil spring formed using a metal material. Similarly, the upper end portion of the second movable piece 23Bc is connected to the elastic member 23Ba. In the following description, the second movable piece 23Ac and the elastic member 23Aa may be collectively called the second movable mechanism 23A, and the second movable piece 23Bc and the elastic member 23Ba may be collectively called the second movable mechanism 23B. The elastic members 23Aa and 23Ba generate an elastic force in the direction of pushing down the second movable pieces 23Ac and 23Bc in response to being compressed in the vertical direction. The elastic members 23Aa and 23Ba are not limited to coil springs, and may be leaf springs or the like.

FIG. 2 is a view showing multiple electronic components mounted on a strip-shaped substrate SB1, and is a cross-sectional view from a side of FIG. 1. In the illustrated example, the first movable piece 22Ac is movable independently corresponding to each of the multiple electronic components CH11 and CH12, and the second movable piece 23Ac is configured as an integrated structure that faces the entire strip-shaped substrate. The second movable piece 23Ac may be divided into multiple parts so as to be arranged independently for each first movable piece 22Ac. As shown in FIG. 2, the second movable piece 23Ac has a through hole 23Ad formed in substantially the same shape as the lower surface of the electronic component CH11 corresponding to the second movable piece 23Ac. The lower end portion 23Ae of the through hole 23Ad is filleted (chamfered). Therefore, the bonding material SN11 that protrudes from the lower surface of the electronic component CH11 to the upper surface of the substrate SB1 is pressurized into a fillet shape and firmly fixed to the substrate SB1. The lower end portion 23Ae may not be filleted.

In the illustrated example, since two or more electronic components CH11, CH12... are simultaneously mounted on the substrate SB1, multiple through holes 23Ad respectively corresponding to the electronic components CH11, CH12... are formed in one first movable piece 22Ac. Each of the first movable pieces 22Ac is inserted through the through hole 23Ad to be movable independently. In the illustrated example, one first movable piece 22Ac is inserted through each of the two through holes.

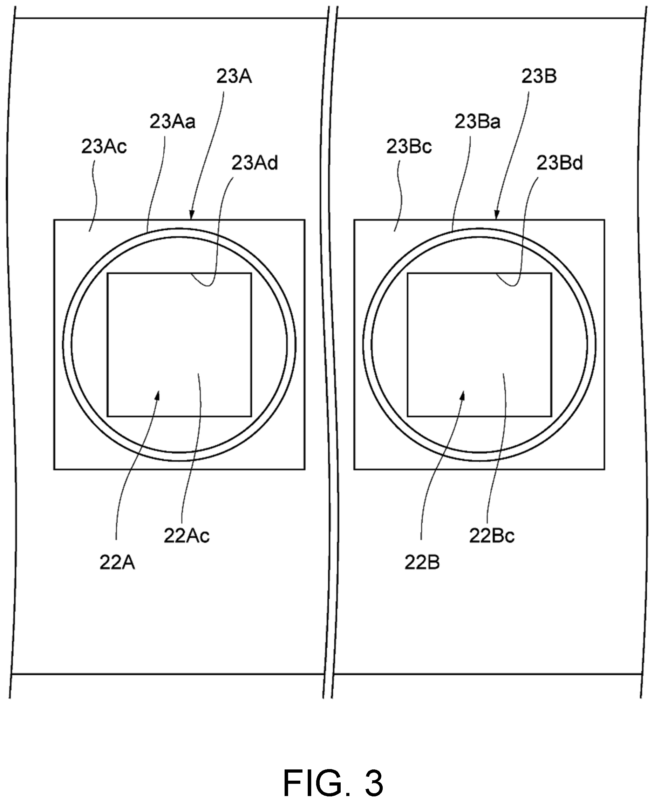

FIG. 3 is a part of a cross-sectional view from the upper portion to the lower side of the elastic members 23Aa and 23Ba shown in FIG. 1. In the illustrated example, the second movable pieces 23Ac and 23Bc are configured to move independently for the first movable pieces 22Ac and 22Bc, respectively. In the illustrated example, the elastic member 23Aa is a coil spring having an inner diameter larger than the through hole 23Ad of the second movable piece 23Ac, and is arranged such that the center of the through hole 23Ad coincides with the center of the coil spring. As in the example shown in FIG. 2, in the case where multiple through holes 23Ad are formed in one second movable piece 23Ac, it is sufficient that multiple coil springs are arranged evenly, and it is not required to arrange a coil spring for each electronic component. Therefore, the number of coil springs is not limited to the illustrated example.

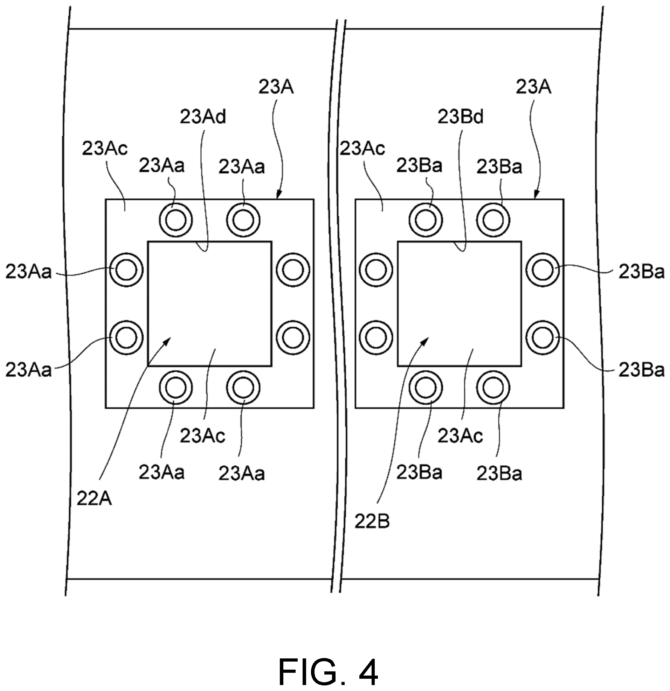

FIG. 4 is a part of a cross-sectional view from the upper portion to the lower side of the elastic members 23Aa and 23Ba shown in FIG. 1, similar to FIG. 3. In the illustrated example, the second movable pieces 23Ac and 23Bc are configured to move independently for the first movable pieces 22Ac and 22Bc, respectively. The elastic member 23Aa may be multiple coil springs arranged at intervals. In the case where the outer shape of the second movable piece 23Ac is rectangular, four coil springs may be arranged at the four corners of the rectangular second movable piece 23Ac. In the illustrated example, eight coil springs are arranged at uniform positions.

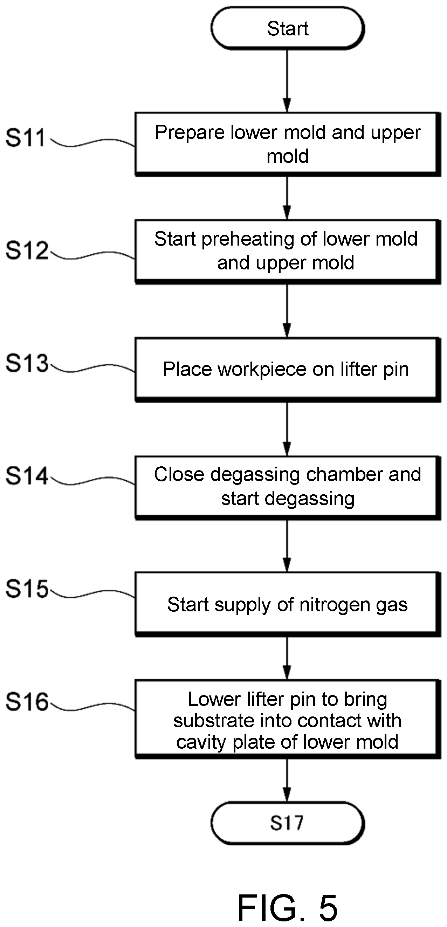

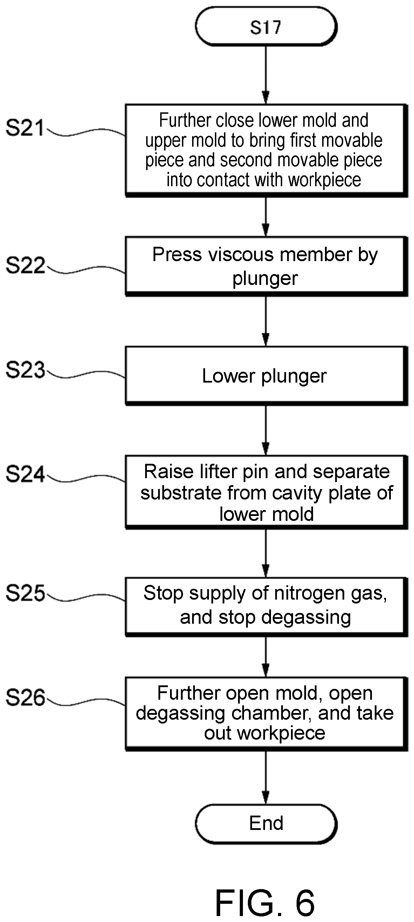

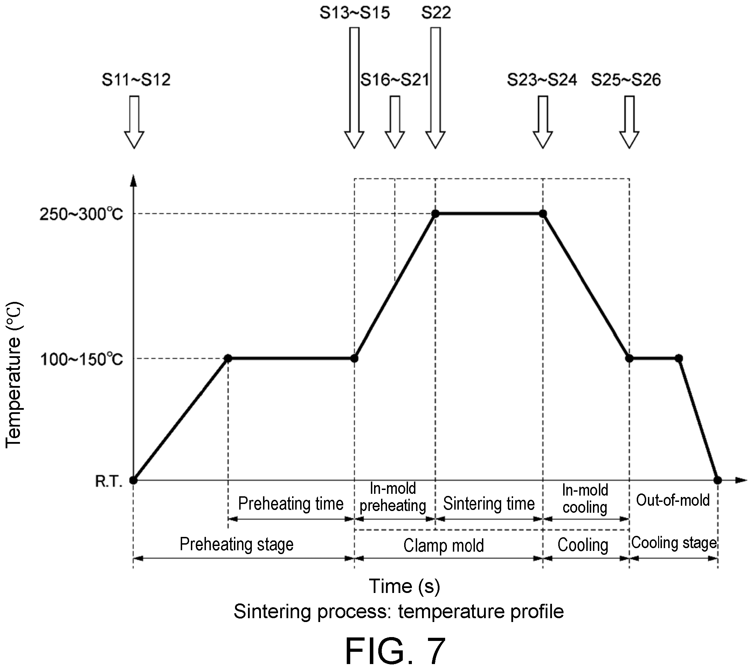

Next, a mounting method using the mounting device 1 according to the present embodiment will be described with reference to FIG. 5 to FIG. 11. FIG. 5 and FIG. 6 are flow diagrams showing an example of the mounting method using the mounting device 1 according to one embodiment of the present invention for mounting multiple electronic components on a substrate. FIG. 7 is a graph showing the temperature profile of the mounting method according to one embodiment of the present invention. In the graph of FIG. 7, the horizontal axis indicates time and the vertical axis indicates the temperature of the workpiece.

The mounting method shown in FIG. 5 and FIG. 6 is a mounting method for mounting an electronic component on a substrate by heating and pressurizing a bonding material, and includes that each first movable piece pressurizes the upper surface of the electronic component corresponding to the first movable piece, and the second movable piece pressurizes one of the bonding material protruding from the lower surface of the electronic component corresponding to the second movable piece to the upper surface of the substrate and the upper surface of the substrate.

The mounting method includes first preparing a lower mold and an upper mold (S11). As described above, the upper mold is provided with at least one first movable piece capable of moving up and down, and a second movable piece capable of moving up and down independently of the first movable piece.

Next, preheating of the lower mold and the upper mold is started (S12). As shown in FIG. 7, the temperature of the workpiece at this time is room temperature (R.T.). The workpiece is placed on the lifter pins (S13). The degassing chamber is closed and degassing is started (S14), and supply of nitrogen gas is started (S15). By degassing and creating a nitrogen gas atmosphere before raising the temperature of the bonding material to the sintering processing temperature, oxidation of the bonding material is suppressed.

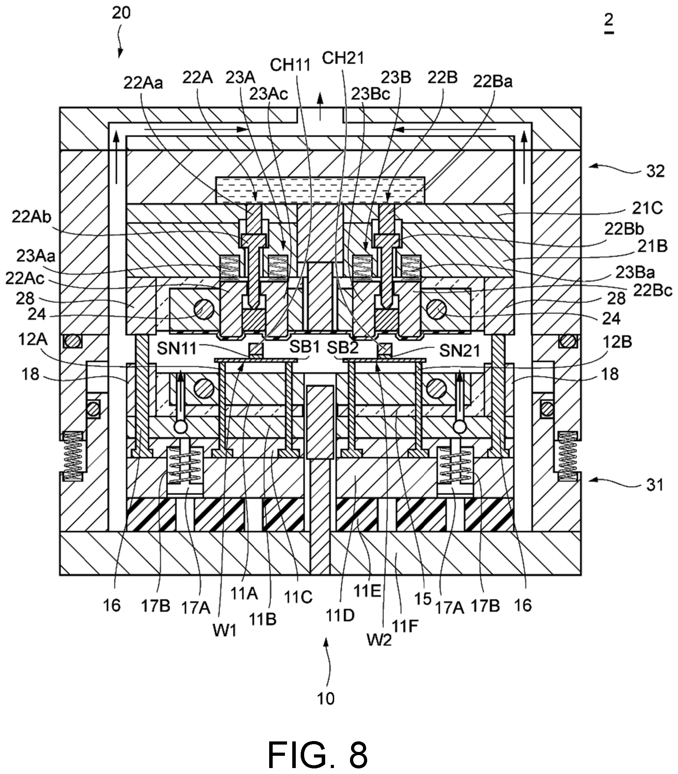

FIG. 8 is a cross-sectional view showing a state in which the degassing chamber 30 is closed and inert gas is supplied while degassing. In the case of the mold 2 being closed from the position shown in FIG. 1 to the position shown in FIG. 8 and the degassing chamber 30 being sealed, the lifter pins 12A and 12B protrude upward from the cavity plate 11A. Therefore, there is a distance between the substrates SB1 and SB2 and the cavity plate 11A of the lower mold 10. The electronic components CH11 and CH21 are gradually heated by thermal radiation. The temperature of the workpieces W1 and W2 at this time is approximately 100°C to 150°C, as shown in FIG. 7.

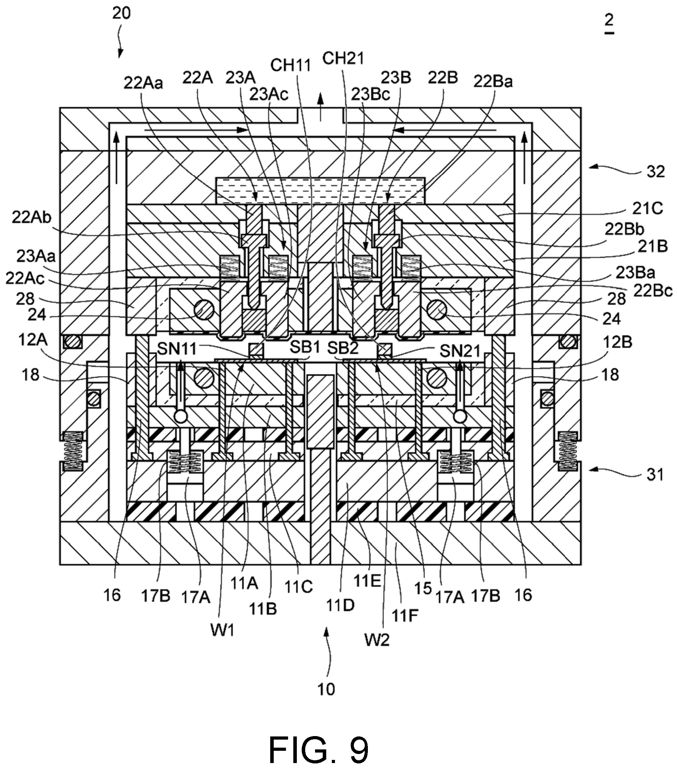

Next, the mold 2 is further closed to the position shown in FIG. 9, and the lifter pins 12A and 12B are lowered by the pressing force applied from the upper mold 20 to the set pin 16 (S16). The pushed down set pin 16 pushes down the ejector pin plate 11C and the retainer plate 11D connected to the base portion of the set pin 16, and pushes down the lifter pins 12A and 12B whose base portions are connected to the ejector pin plate 11C and the retainer plate 11D. As a result, the workpieces W1 and W2 come into contact with the cavity plate 11A.

FIG. 9 is a cross-sectional view showing a state in which the substrates SB1 and SB2 are in contact with the heated cavity plate 11A. The substrates SB1 and SB2 are heated by heat conduction from the cavity plate 11A of the lower mold 10, and the electronic components CH11 and CH21 are not in contact with the first movable pieces 22Ac and 22Bc of the upper mold 20, but are heated by thermal radiation. As shown in FIG. 7, at this time, the temperature of the workpieces W1 and W2 is raised from the preheating temperature of 100°C to 150°C to the sintering processing temperature of 250°C to 300°C.

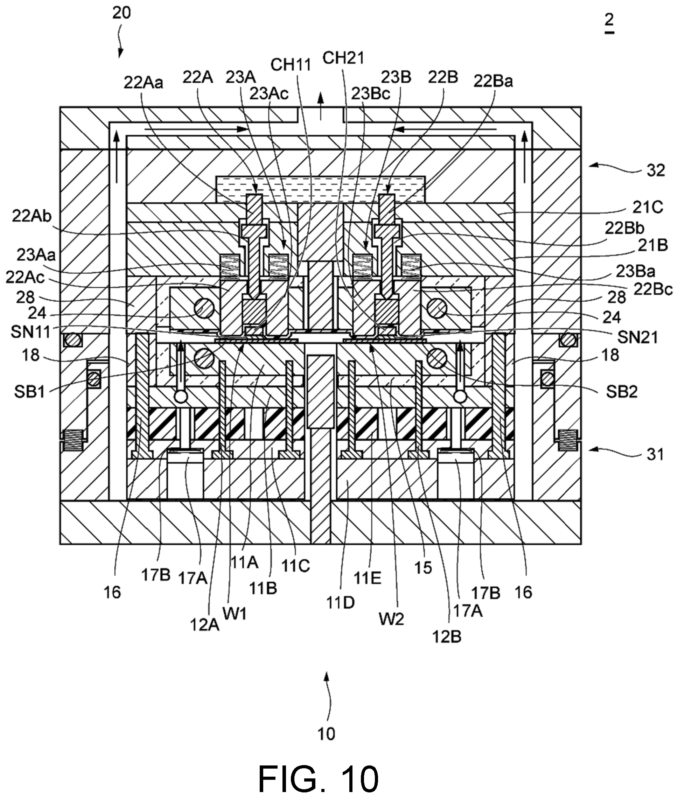

Next, the mold 2 is closed to the position shown in FIG. 10, and the first movable pieces 22Ac and 22Bc and the second movable pieces 23Ac and Bc are brought into contact with the workpieces W1 and W2 (S21). In this process, the second movable pieces 23Ac and 23Bc come into contact with the upper surfaces of the substrates SB1 and SB2 via the film F to prevent the bonding materials SN11 and SN21 from protruding to the surroundings from the lower surfaces of the electronic components CH11 and CH21 to the upper surfaces of the substrates SB1 and SB2, and pressurize the substrates SB1 and SB2 by the elastic force of the elastic members 23Aa and 23Ba.

By further closing the mold, the first movable pieces 22Ac and 22Bc come into contact with the electronic components CH11 and CH21 via the films F, and by further closing the mold, the pistons 22Aa and 22Ba that receive pressure from the viscous member 26V are pushed up. As a result of this process, the state shown in FIG. 10 is achieved.

The dimensional differences of the substrates SB1 and SB2, the bonding materials SN11 and SN21, and the electronic components CH11 and CH21 are absorbed by the penetration depth of the pistons 22Aa and 22Ba into the closed space 26. At this time, the temperature of the workpieces W1 and W2 is raised from the preheating temperature of 100°C to 150°C to the sintering processing temperature of 250°C to 300°C, as shown in FIG. 7.

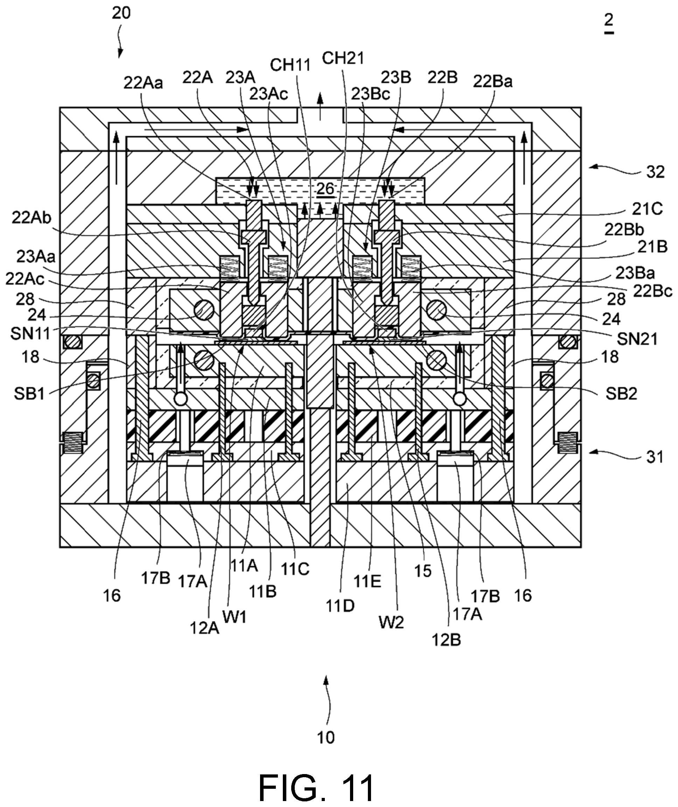

Next, the viscous member 26V is pressed by the plunger PR (S22). FIG. 11 shows a state in which the upper surfaces of the electronic components CH11 and CH21 are pressurized by the first movable pieces 22Ac and 22Bc, and the bonding materials SN11 and SN21 that protrude from the lower portions of the electronic components CH11 and CH21 are clamped by the second movable pieces 23Ac and 23Bc on the substrates SB1 and SB2 via the film such that the bonding materials protrude to the filleted lower end portions 23Ae and 23Be of the second movable pieces and are being pressurized without leaking beyond that. As shown in FIG. 11, in the case of pushing up the lower plunger PR1 by a known transfer mechanism when the lower mold 10 and the upper mold 20 are closed, the tip portion of the upper plunger PR2 comes into contact with the tip portion of the lower plunger PR1, and the upper plunger PR2 is pushed up by the lower plunger PR1. It is more preferable that when the lower mold 10 and the upper mold 20 are closed, the tip portion of the upper plunger PR2 is in contact with the tip portion of the lower plunger PR1 even if the lower plunger PR1 is not pushed up by the transfer mechanism, because the movable amount of the lower plunger PR1 directly becomes the movable amount of the upper plunger.

The lower plunger PR1 presses the viscous member 26V with a predetermined pressing force via the upper plunger PR2. The internal pressure of the closed space 26, which is pressed by the upper plunger PR2 and raised, is equally applied to the pistons 22Aa and 22Ba. The bonding materials SN11 and SN21 are sintered by heating and pressurization for a predetermined time, and the electronic components CH11 and CH21 and the substrates SB1 and SB2 are bonded by the sintered bonding materials SN11 and SN21. Thereby, the electronic components CH11 and CH21 are mounted on the substrates SB1 and SB2. Next, the pressing force of the lower plunger PR1 is stopped, and the lower plunger PR1 is lowered. (S23)

Then, in response to the mold being opened to the position shown in FIG. 8, the ejector pin plate 11C and the retainer plate 11D rise due to the biasing force of the spring 17B, and the lifter pins 12A and 12B fixed to the ejector pin plate 11C and the retainer plate 11D rise. The substrates SB1 and SB2 are separated from the cavity plate 11A of the lower mold 10 (S24). The supply of inert gas such as nitrogen gas is stopped, and degassing is stopped (S25). The mold 2, 3 is opened to the position shown in FIG. 1, the lifter pins 12A and 12B are raised, and the substrates SB1 and SB2 are taken out of the mold 2 (S26).

According to the mounting device 1 of the present embodiment configured as described above and the mounting method using this mounting device 1, the electronic component CH11 is pressurized by the first movable piece 22Ac, and furthermore, the bonding material SN11 that protrudes in a fillet shape from the lower surface of the electronic component CH11 to the upper surface of the substrate SB1 is pressurized by the second movable piece 23Ac, so it is possible to firmly bond the electronic component CH11 to the substrate SB1 to suppress the occurrence of mounting defects.

Since not only the bonding material SN11 directly below the electronic component CH11 but also the bonding material SN11 in the fillet range that extends beyond the region directly below the electronic component CH11 can be heated while being pressurized, the bonding material SN11 is less likely to fall off in any range, making it possible to suppress the generation of dust that contaminates the inside of the mold 2.

Further, depending on the type of the substrate SB1, the substrate SB1 may be slightly warped due to stress. Since the substrate SB1 is not pressurized via the electronic component CH11 in regions not directly below the electronic component CH11, the substrates SB1 and SB2 may float from the lower mold 10 in the case of being warped. According to this aspect, the second movable pieces 23Ac and 23Bc pressurize the substrates SB1 and SB2, thereby correcting the warping of the substrates SB1 and SB2. Additionally, although the second movable pieces 23Ac and 23Bc have the lower end portions 23Ae filleted, the lower end portions 23Ae may not be filleted in the case of aiming only to correct the warping of the substrates.

The embodiments described above are provided to facilitate understanding of the present invention, and not to limit interpretation of the present invention. Each element included in the embodiments and the arrangement, material, conditions, shape, and size thereof are not limited to those illustrated and may be changed as appropriate. Additionally, configurations shown in different embodiments may be partially substituted or combined with each other.

For example, the configuration of the pressure adjustment mechanism 9 is not limited to the illustrated example. The configuration of the pressure adjustment mechanism 9 may be made to absorb differences in thickness of the substrates SB1 and SB2, differences in height of the electronic components CH11 and CH21, and differences in thickness of the bonding materials SN11 and SN21 by, for example, springs or the like instead of the viscous member 26V, and to pressurize the bonding materials SN11 and SN21 with substantially equal pressure. Springs or the like with different spring constants may be selected to make the pressure applied to each of the electronic components CH11 and CH21 differ from each other.

### [Supplementary Note 1]

The mounting device 1 is a mounting device for mounting at least one electronic component CH11, CH21... on each of at least one substrate SB1, SB2... by heating and pressurizing the bonding materials SN11, SN21..., and includes: the lower mold 10 configured to hold the substrates SB1, SB2...; the upper mold 20 disposed opposite to the lower mold 10; the first movable pieces 22Ac, 22Bc... provided in the upper mold 20 and capable of moving up and down to pressurize the upper surface of each of the electronic components CH11, CH21...; and at least one second movable piece 23Ac, 23Bc... provided in the upper mold 20 and capable of moving up and down independently of the first movable pieces 22Ac, 22Bc... The mounting device 1 is configured such that the second movable pieces 23Ac, 23Bc... pressurize the bonding materials SN11, SN21... protruding from the lower surfaces of the electronic components CH11, CH21... corresponding to the second movable pieces to the upper surfaces of the substrates SB1, SB2... and the upper surfaces of the substrates SB1, SB2...

### [Supplementary Note 9]

The mounting method is a mounting method for mounting at least one electronic component CH11, CH21... on each of at least one substrate SB1, SB2... by heating and pressurizing the bonding materials SN11, SN21..., and includes: preparing the lower mold 10 configured to hold the substrates SB1, SB2...; preparing the upper mold 20 disposed opposite to the lower mold 10; preparing the first movable pieces 22Ac, 22Bc... provided in the upper mold 20 and capable of moving up and down to pressurize the upper surface of each of the electronic components CH11, CH21...; and preparing at least one second movable piece 23Ac, 23Bc... provided in the upper mold 20 and capable of moving up and down independently of the first movable pieces 22Ac, 22Bc... The mounting method further includes the second movable pieces 23Ac, 23Bc... pressurizing the bonding materials SN11, SN21... protruding from the lower surfaces of the electronic components CH11, CH21... corresponding to the second movable pieces to the upper surfaces of the substrates SB1, SB2... and the upper surfaces of the substrates SB1, SB2...

According to the supplementary notes 1 and 9 described above, the bonding materials SN11, SN21... are disposed to protrude from the lower surfaces of the electronic components CH11, CH21... to the upper surfaces of the substrates SB1, SB2..., so the electronic components CH11, CH21... can be firmly bonded to the substrates SB1, SB2... to suppress the occurrence of mounting defects. Furthermore, the bonding materials SN11, SN21... directly below the electronic components CH11, CH21... are pressurized by the first movable pieces 22Ac, 22Bc..., and the bonding materials SN11, SN21... that protrude from the lower surfaces of the electronic components CH11, CH21... to the upper surfaces of the substrates SB1, SB2... are pressurized by the second movable pieces 23Ac, 23Bc... Since not only the bonding materials SN11, SN21... directly below the electronic components CH11, CH21... but also the bonding materials SN11, SN21... in the range outside the region directly below the electronic components CH11, CH21... can be heated in a pressurized state, the bonding materials SN11, SN21... are less likely to fall off in any range. Generation of dust that contaminates the inside of the mold 2 can be suppressed. Further, depending on the types of the substrates SB1, SB2..., the substrates SB1, SB2... may be slightly warped due to stress. Since the substrates SB1, SB2... are not pressurized via the electronic components CH11, CH21... in regions not directly below the electronic components CH11, CH21..., the substrates SB1, SB2... may float without adhering closely to the lower mold 10 when supplied to the mold 2 in the case of the substrates SB1, SB2... being warped. According to the supplementary notes 1 and 9 described above, the second movable pieces 23Ac, 23Bc... can also pressurize the substrates SB1, SB2... to correct the warping of the substrates SB1, SB2...

### [Supplementary Note 2]

In the supplementary note 1 described above, the mounting device 1 may further include: the viscous member 26V sealed in the closed space 26 within the upper mold 20; and the pressure adjustment mechanism 9 adjusting the internal pressure of the viscous member 26V. Each of the first movable pieces 22Ac, 22Bc... may be configured to receive the internal pressure of the viscous member 26V and pressurize the upper surfaces of the electronic components CH11, CH21...

The electronic components CH11, CH21... have slight differences in dimensions within the tolerance range. In addition, the supply amounts of the bonding materials SN11, SN21... have slight differences. Therefore, in a mounting device that simultaneously pressurizes multiple electronic components CH11, CH21..., the pressure applied to the electronic components CH11, CH21... may be insufficient or excessive compared to the ideal value due to dimensional differences of the electronic components CH11, CH21... According to the supplementary note 2 described above, the multiple first movable pieces 22Ac, 22Bc... receive the same internal pressure from the viscous member 26V sealed in the closed space 26 of the upper mold 20 and move up and down, making it possible to apply substantially equal pressure to the multiple electronic components CH11, CH21... The occurrence of mounting defects caused by insufficient or excessive pressure applied to the electronic components CH11, CH21... can be suppressed. Furthermore, according to the supplementary note 2 described above, the viscous member that moves the first movable pieces 22Ac, 22Bc... up and down neither flows in from outside the upper mold 20 nor flows out to the outside of the upper mold 20. Therefore, the mounting device 1 can be made more compact than a configuration that moves the first movable pieces 22Ac, 22Bc... up and down via fluid supplied from outside the upper mold 20.

In the supplementary note 2 described above, the pressure adjustment mechanism 9 may include: the upper plunger PR2 provided in the upper mold 20 and capable of advancing and retracting such that the volume of the closed space 26 contracts and expands; and the lower plunger PR1 provided in the lower mold 10 and coming into contact with the upper plunger PR2 to advance and retract the upper plunger PR2 in the case of heating and pressurizing the bonding materials SN11, SN21...

According to the supplementary note 3 described above, the plunger that adjusts the internal pressure of the viscous member 26V can be divided into the lower plunger PR1 and the upper plunger PR2. Compared to a configuration using a long plunger that cannot be divided, the present invention facilitates mold opening of the upper and lower molds and has fewer constraints in design, makes it easier for maintenance, and can achieve miniaturization of the mounting device 1.

### [Supplementary Note 4]

In the supplementary note 1 described above, the second movable pieces 23Ac, 23Bc... may be connected to the elastic members 23Aa, 23Ba... and configured to pressurize the bonding materials SN11, SN21... protruding from the lower surfaces of the electronic components CH11, CH21... to the upper surfaces of the substrates SB1, SB2... and the upper surfaces of the substrates SB1 and SB2 by the elastic force of the elastic members 23Aa, 23Ba...

According to the supplementary note 4 described above, the upward movement of the movable mechanism generates an elastic force in the elastic member, and the electronic components are pressurized by this elastic force. In other words, the elastic force suitable for pressurizing the electronic components is naturally generated within the mold. Therefore, the mounting device 1 can be made more compact than a configuration that moves the first movable pieces 22Ac, 22Bc... up and down via fluid supplied from outside the upper mold 20.

### [Supplementary Note 5]

In the supplementary note 1 described above, the second movable pieces 23Ac, 23Bc... may have the through holes 23Ad, 23Bd... formed therein that have substantially the same shape as the lower surfaces of the electronic components CH11, CH21... corresponding to the second movable pieces 23Ac, 23Bc...

According to the supplementary note 5 described above, since the lower surfaces of the electronic components CH11, CH21... and the through holes 23Ad, 23Bd... corresponding to the electronic components have substantially the same shape, the second movable pieces 23Ac, 23Bc... can pressurize the substrates SB1, SB2... in the immediate vicinity of the electronic components CH11, CH21...

### [Supplementary Note 6]

In the supplementary note 5 described above, the lower end portions 23Ae and 23Be of the through holes 23Ad, 23Bd... may be filleted.

According to the supplementary note 6 described above, the bonding materials SN11, SN21... that protrude from the lower surfaces of the electronic components CH11, CH21... to the upper surfaces of the substrates SB1, SB2... are filled into the filleted lower end portions 23Ae and 23Be.

### [Supplementary Note 7]

In the supplementary note 6 described above, the filleted lower end portions 23Ae and 23Be may be configured to pressurize the bonding materials SN11, SN21... that protrude from the lower surfaces of the electronic components CH11, CH21... to the upper surfaces of the substrates SB1, SB2...

According to the supplementary note 7 described above, the bonding materials SN11, SN21... that protrude from the lower surfaces of the electronic components CH11, CH21... to the upper surfaces of the substrates SB1, SB2... are firmly fixed to the substrates SB1 and SB2.

### [Supplementary Note 8]

In the supplementary note 5 described above, the first movable pieces 22Ac, 22Bc... may be inserted through the through holes 23Ad, 23Bd...

According to the supplementary note 8 described above, the first movable pieces 22Ac, 22Bc... and the second movable pieces 23Ac, 23Bc... can be moved up and down independently of each other.

### Description of Reference Numerals

1...mounting device, 2...mold, 3...press device, 4...movable platen, 5...upper platen, 9...pressure adjustment mechanism, 10...lower mold, 11A...cavity plate, 11B...lower mold chase, 11C...ejector pin plate, 11D...retainer plate, 11E...support pillar, 11F...lower mold base, 12A, 12B...lifter pin, 13...gas supply port, 14...heater, 15...thermal insulation member, 16...set pin, 17A...spring sleeve, 17B...spring, 18...side block, 20...upper mold, 21A...cavity plate, 21B...upper mold chase, 21C...lower support plate, 21D...upper support plate, 21E...upper mold base, 22A, 22B...first movable mechanism, 22Aa, 22Ba...piston, 22Ab, 22Bb...rod, 22Ac, 22Bc...first movable piece, 23A, 23B...second movable mechanism, 23Aa, 23Ba...elastic member, 23Ac, 23Bc...second movable piece, 23Ad, 23Bd...through hole, 23Ae, 23Be...lower end portion, 24...heater, 25...thermal insulation member, 26...closed space, 27...degassing path, 28...side block, 29...degassing port, 30...degassing chamber, 31...lower chamber, 32...upper chamber, 33, 34...degassing path, CH11, CH12, CH21...electronic component, PR...plunger, PR1...lower plunger, SB1, SB2...substrate, SN11, SN12, SN21...bonding material, W1, W2...workpiece.

## Claims

1. A mounting device for mounting at least one electronic component on each of at least one substrate by heating and pressurizing a bonding material, the mounting device comprising:
a lower mold configured to hold the substrate;
an upper mold disposed opposite to the lower mold;
a first movable piece provided in the upper mold and capable of moving up and down to pressurize an upper surface of each of the electronic components; and
at least one second movable piece provided in the upper mold and capable of moving up and down independently of the first movable piece, and
the mounting device being configured such that the second movable piece pressurizes the bonding material protruding from a lower surface of the electronic component corresponding to the second movable piece to an upper surface of the substrate and the upper surface of the substrate.

2. The mounting device according to claim 1, further comprising:
a viscous member sealed in a closed space within the upper mold; and
a pressure adjustment mechanism adjusting internal pressure of the viscous member,
wherein the first movable piece is each configured to receive the internal pressure of the viscous member and pressurize the upper surface of the electronic component.

3. The mounting device according to claim 2, wherein the pressure adjustment mechanism comprises:
an upper plunger provided in the upper mold and capable of advancing and retracting such that a volume of the closed space contracts and expands; and
a lower plunger provided in the lower mold and coming into contact with the upper plunger to advance and retract the upper plunger in the case of heating and pressurizing the bonding material.

4. The mounting device according to claim 1, wherein the second movable piece is connected to an elastic member and is configured to pressurize the bonding material protruding from the lower surface of the electronic component to the upper surface of the substrate and the upper surface of the substrate by an elastic force of the elastic member.

5. The mounting device according to claim 1, wherein the second movable piece has a through hole formed therein that has substantially the same shape as the lower surface of the electronic component corresponding to the second movable piece.

6. The mounting device according to claim 5, wherein a lower end portion of each of the through holes is filleted.

7. The mounting device according to claim 6, wherein the filleted lower end portion is configured to pressurize the bonding material protruding from the lower surface of the electronic component to the upper surface of the substrate.

8. The mounting device according to claim 5, wherein the first movable piece is inserted through the through hole.

9. A mounting method for mounting at least one electronic component on each of at least one substrate by heating and pressurizing a bonding material, the mounting method comprising:
preparing a lower mold configured to hold the substrate;
preparing an upper mold disposed opposite to the lower mold;
preparing a first movable piece provided in the upper mold and capable of moving up and down to pressurize an upper surface of each of the electronic components; and
preparing at least one second movable piece provided in the upper mold and capable of moving up and down independently of the first movable piece, and
the mounting method further comprising the second movable piece pressurizing the bonding material protruding from a lower surface of the electronic component corresponding to the second movable piece to an upper surface of the substrate and the upper surface of the substrate.
